# EUROPEAN PATENT APPLICATION

(11) **EP 1 612 844 A1**
(43) Date of publication of application: **04.01.2006**
(21) Application number: 05253789.1
(22) Date of filing: 17.06.2005
(51) Int. Cl.: H01L 21/00, B08B 3/04, B08B 3/00

(54) **Self-draining edge wheel system and method**

(30) Priority: 30.06.2004 US 882934
(71) Applicant: LAM RESEARCH CORPORATION, Fremont, CA 94538 (US)
(72) Inventor: Garcia, James P., Santa Clara, California 95050 (US); Redeker, Fritz, Fremont, California 94539 (US)
(74) Representative: Thomson, Paul Anthony

(57) **Abstract**

Provided is a system and method to prevent the transfer of accumulated fluid to wafers during cleaning operations. Specifically, when a wafer is secured by a plurality of self-draining edge wheels, any fluid contacting the self-draining edge wheels is channeled away from the wafer towards a bottom surface of each of the self-draining edge wheels. The channeling occurs by manufacturing the bottom portions of the self-draining edge wheels to have different configurations. The different configurations enhance fluid channeling away from the wafer. To further prevent fluid from wetting a bottom surface of the self-draining edge wheels, an edge wheel dryer can be positioned proximately adjacent to at least one self-draining edge wheel to suction fluid away from the bottom surface by using a vacuum channel of the edge wheel dryer.

## Description

### BACKGROUND

### 1. Field of the Invention

The present invention relates to semiconductor fabrication, and more specifically, to a self-draining edge wheel for use in semiconductor wafer processing systems.

### 2. Description of the Related Art

Semiconductor wafer fabrication operations are typically performed in a repetitive series of fabrication steps. For example, a series of fabrication steps include implantation, material deposition, photolithography, etching, and planarization. The series repeats until the semiconductor wafer is completely fabricated. However, the repetitive series of fabrication steps can produce residue that can remain on a surface of the semiconductor wafer. Residue includes particulates and other undesirable material that can contaminate the metallization lines and structures of the semiconductor wafer. Exemplary particulates can include, among many others, silica, silicon dust, silicate particulates, slurry residue, and metal flakes.

To remove the residue, current semiconductor wafer processing systems include cleaning systems to clean the semiconductor wafers. Specifically, fluid is applied to the semiconductor wafer to wet any residue. Then, the fluid can be removed. However, any structure supporting the wafer at the edge may accumulate the fluid. The accumulated fluid may cause a body of fluid to form at the edge and the structure. Then, the accumulated fluid may recontaminate the semiconductor wafer by possibly reintroducing the particulates that were cleaned.

Another possible problem may result from the accumulated fluid rewetting a dried semiconductor wafer. Specifically, after the semiconductor wafer has been dried, any accumulated fluid on the structure supporting the semiconductor wafer can reapply fluid to the dried semiconductor wafer. Thus, another operation may be required to completely dry the semiconductor wafer.

In view of the foregoing, what is needed is a system and method for preventing the transfer of accumulated fluid on a wafer support structure to semiconductor wafers during a cleaning operation.

### SUMMARY OF THE INVENTION

Broadly speaking, the present invention is a system and method for preventing the transfer of accumulated fluid to semiconductor wafers during a cleaning operation. Specifically, fluid can accumulate at a semiconductor wafer edge. The fluid at the semiconductor wafer edge transfers to a structure, such as an edge wheel supporting the semiconductor wafer edge. By configuring the edge wheel to drain the fluid and thereby prevent fluid accumulation, the fluid does not transfer to the semiconductor wafer being cleaned. It can be appreciated that the present invention can be implemented in numerous ways, such as a process, an apparatus, a system, or a device. Several inventive embodiments of the present invention are described below.

In an embodiment of a method for processing a wafer, the method includes supporting a wafer with a plurality of edge wheels positioned peripherally around the wafer. The plurality of edge wheels are capable of rotating so as to rotate the wafer. The method also includes causing a fluid present on a surface of the wafer to move toward the plurality of edge wheels to reach an interface formed between an edge of the wafer and a surface of each of the plurality of edge wheels. Further, the method includes channeling the fluid contacting the plurality of edge wheels away from the interface, such that the channeling of the fluid is configured to prevent formation of a meniscus of the fluid at the interface.

In another embodiment of a method for processing a wafer, the method includes supporting a wafer with a plurality of edge wheels positioned peripherally around the wafer. The plurality of edge wheels are capable of rotating so as to rotate the wafer. The method also includes causing a fluid present on a surface of the wafer to move toward the plurality of edge wheels to reach an interface formed between an edge of the wafer and a surface of each of the plurality of edge wheels. Further, the method includes channeling the fluid contacting the plurality of edge wheels away from the interface, such that the channeling of the fluid is configured to prevent formation of a meniscus of the fluid at the interface. The method also includes suctioning the fluid from each of the plurality of edge wheels, such that the suctioning is configured to keep a bottom surface of each of the plurality of edge wheels substantially dry.

In an embodiment of an edge wheel for processing a wafer, the edge wheel includes a top portion and a bottom portion forming a groove therebetween for receiving an edge of a wafer. The bottom portion is configured to channel fluid away from the groove to prevent formation of a meniscus of fluid between the groove and the edge of the wafer.

An embodiment of a system for processing a wafer includes a plurality of edge wheels for supporting a wafer, such that each of the plurality of edge wheels has a top portion and a bottom portion forming a groove therebetween for receiving an edge of a wafer. The bottom portion is configured to channel fluid away from the groove to prevent formation of a meniscus of fluid between the groove and the edge of the wafer. The system also includes an edge wheel dryer disposed proximate to the plurality of edge wheels, the edge wheel dryer having a plurality of vacuum channels configured to suction fluid away from the bottom portion of each of the plurality of edge wheels.

In an embodiment of a method for processing a wafer, the method includes supporting a wafer with a plurality of edge wheels positioned peripherally around the wafer. The method also includes applying a volume of fluid on a surface of the wafer, such that the volume of fluid is sufficient to cause the fluid to move toward the plurality of edge wheels to reach an interface formed between an edge of the wafer and a surface of each of the plurality of edge wheels. Further, the method includes channeling the fluid contacting the plurality of edge wheels away from the interface, such that the channeling of the fluid is configured to prevent formation of a meniscus of the fluid at the interface.

In an embodiment of a method for processing a wafer, the method includes supporting a wafer with a plurality of edge wheels positioned peripherally around the wafer. The method also includes applying a volume of fluid on a surface of the wafer, such that the volume of fluid is sufficient to cause the fluid to move toward the plurality of edge wheels to reach an interface formed between an edge of the wafer and a surface of each of the plurality of edge wheels. Further, the method includes channeling the fluid contacting the plurality of edge wheels away from the interface, such that the channeling of the fluid is configured to prevent formation of a meniscus of the fluid at the interface. The method also includes suctioning the fluid from each of the plurality of edge wheels, such that the suctioning is configured to keep a bottom surface of each of the plurality of edge wheels substantially dry.

Other aspects of the invention will become apparent from the following detailed description, taken in conjunction with the accompanying drawings, illustrating by way of example the principles of the invention.

### BRIEF DESCRIPTION OF THE DRAWINGS

Embodiments of the invention may best be understood by reference to the following description, taken in conjunction with the accompanying drawings, in which:

Figure 1A is a side view diagram illustrating a cleaning system, in accordance with an embodiment of the invention;

Figure 1B is a top view diagram illustrating a cleaning system, in accordance with another embodiment of the invention;

Figure 1C is a top view diagram illustrating a cleaning system, in accordance with yet another embodiment of the invention;

Figure 2A is a side view diagram illustrating a self-draining edge wheel with an internal chamber, in accordance with an embodiment of the invention;

Figure 2B is a side view diagram illustrating a self-draining edge wheel with an internal chamber, in accordance with an embodiment of the invention;

Figure 3A is a side view diagram illustrating a self-draining edge wheel with cut out regions, in accordance with an embodiment of the invention;

Figure 3B is a bottom view diagram illustrating a self-draining edge wheel with cut out regions, in accordance with an embodiment of the invention;

Figure 4A is a side view diagram illustrating a self-draining edge wheel having a plurality of legs, in accordance with an embodiment of the invention;

Figure 4B is a bottom view diagram illustrating a self-draining edge wheel having a plurality of legs, in accordance with an embodiment of the invention;

Figure 5A is a bottom view diagram illustrating a self-draining edge wheel with angled channels, in accordance with an embodiment of the invention;

Figure 5B is a side view diagram illustrating a self-draining edge wheel with angled channels, in accordance with an embodiment of the invention;

Figure 6 is a side view diagram illustrating a self-draining edge wheel and a fluid conductor, in accordance with another embodiment of the invention; and

Figure 7 is a flowchart diagram illustrating a method for processing a wafer, in accordance with an embodiment of the invention.

### DETAILED DESCRIPTION

The following descriptions describe embodiments of a system and method for processing a wafer to prevent the transfer of accumulated fluid to wafers during a cleaning operation. Specifically, multiple self-draining edge wheels support the wafer during the cleaning operation. Fluid on a surface of the wafer propagates to an edge of the wafer. Upon reaching the edge of the wafer, the fluid can accumulate. The accumulated fluid can contact the multiple self-draining edge wheels and cause the accumulated fluid to coat a surface of each of the multiple self-draining edge wheels. Thereafter, the fluid coating drains away from the contact point with the edge of the wafer.

The drained fluid can then be suctioned away from the multiple self-draining edge wheels to maintain substantially dry self-draining edge wheels. Otherwise, the drained fluid is removed from the surface of each of the multiple self-draining edge wheels through the self-draining properties of the multiple self-draining edge wheels. It will be obvious, however, to one skilled in the art, that the present invention may be practiced without some or all of these specific details. In other instances, well known process operations have not been described in detail in order not to unnecessarily obscure the present invention.

Further, the embodiments described herein are exemplary. It will be appreciated by those skilled in the art that upon reading the description and studying the drawings, various alterations, additions, permutations and equivalents thereof are possible. It is therefore intended that all such alterations, additions, permutations, and equivalents fall within the true spirit and scope of the disclosed embodiments.

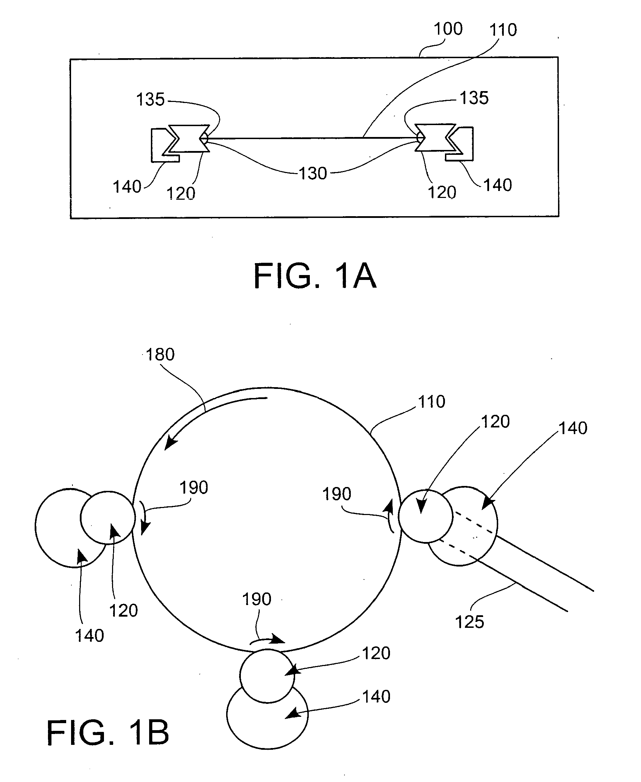

Figure 1A is a side view diagram illustrating a cleaning system 100, in accordance with an embodiment of the invention. As shown in Figure 1A, a wafer 110 is positioned for processing in a cleaning system 100. In some embodiments, the wafer 110 can have a diameter of a 200mm or 300mm. However, one of ordinary skill in the art will recognize that the size of the wafer 110 can vary. In one embodiment, the cleaning system 100 is enclosed in a chamber, as illustrated in Figure 1A. However, other embodiments do not use an enclosed cleaning system for performing cleaning operations on wafer 110. Details regarding an example of a non-enclosed cleaning system will be further described with reference to Figure 3C.

The cleaning system 100 includes a plurality of self-draining edge wheels (edge wheels) 120. As illustrated, the edge wheels 120 support the wafer 110 via an interface. Specifically, the interface is formed between a v-like groove of the edge wheels 120 and the wafer 110. The groove positions the wafer 120 to permit rotation of the wafer 110 and the edge wheel 120. However, other interfaces with different shapes can couple the wafer 110 and the edge wheel 120, as long as the other interfaces form when supporting the wafer 110.

The edge wheels 120 are capable of rotating, thus permitting the rotation of the wafer 110. As the wafer 110 rotates, any fluid on a bottom surface or a top surface of the wafer 110 propagates to an edge of the wafer 110. The edge of the wafer 110 is in contact with each of the edge wheels 120 at the interface. Accordingly, the propagated fluid accumulates on the edge of the wafer 110 and the interface. Specifically, accumulated fluid at a bottom surface 130 and a top surface 135 may form. Each accumulation of fluid may form a meniscus that can contaminate each wafer 110 introduced to the cleaning system 100. However, fluid channeling from the interface prevents formation of the meniscus.

In another embodiment of the present invention, fluid can be applied to the wafer 110 while the wafer is stationary, i.e. not rotating. Here, the volume of fluid applied to the surface of the wafer 110 should be sufficient such that the fluid propagates to the edge of the wafer and the interface. The fluid reaching the interface is channeled away according to the embodiments of the present invention described herein.

Fluid channeling occurs because the edge wheels 120 of the present invention are configured to drain fluid from the interface. For example, in an embodiment of an edge wheel 120 having a bottom portion and a top portion, the bottom portion can be configured to drain fluid away from the interface. In another exemplary embodiment, one or more edge wheel dryers 140 can suction the fluid away from the bottom portion of the edge wheels 120 by using one or more vacuum channels. However, it should be appreciated that the edge wheel dryer 140 may or may not be used to suction fluid from the edge wheel 120. In at least one embodiment of the present invention, the edge wheel 120 is configured to drain fluid without suctioning from an edge wheel dryer 140.

Figure 1B is a top view diagram illustrating the cleaning system 100, in accordance with another embodiment of the invention. The cleaning system 110 can include three edge wheels 120 to support the wafer 110. As the wafer 110 rotates in a direction 180, each of the edge wheels 120 rotate in a direction 190. Further, each edge wheel 120 is illustrated coupled to an edge wheel dryer 140. However, one of ordinary skill will recognize that the inclusion of any edge wheel dryer 140 in Figure 1B is purely exemplary because an edge wheel dryer 140 may or may not be used with an edge wheel 120. Further, although illustrated with three edge wheels dryers 140, other embodiments may include one edge wheel dryer 140 suctioning fluid from all three edge wheels 120. Thus, any configuration of edge wheel dryers 140 and edge wheels 120 is possible, as long as any edge wheel dryer 140 used with at least one edge wheel 120 suctions fluid from at least one edge wheel 120.

At least one edge wheel 120 is coupled to a robotic arm 125. The robotic arm 125 can move the edge wheel 120 and if necessary, any coupled edge wheel dryer 140 away from the wafer 110. By moving the edge wheel 120, the wafer 110 may be moved from or be placed in contact with the grooves of the edge wheels 120. After positioning the wafer 110 in the grooves, the robotic arm 125 moves the edge wheel 120 back to the wafer 110 to secure the wafer 110. However, the edge wheel 120 can be coupled to any other type of mechanical appendage, such as the robotic arm 125, as long as the mechanical appendage can move the edge wheel 120. Further, it should be appreciated that any method of securing the wafer 110 to the interfaces of the edge wheels 120 is possible, as long as the wafer 110 can be secured while permitting rotation.

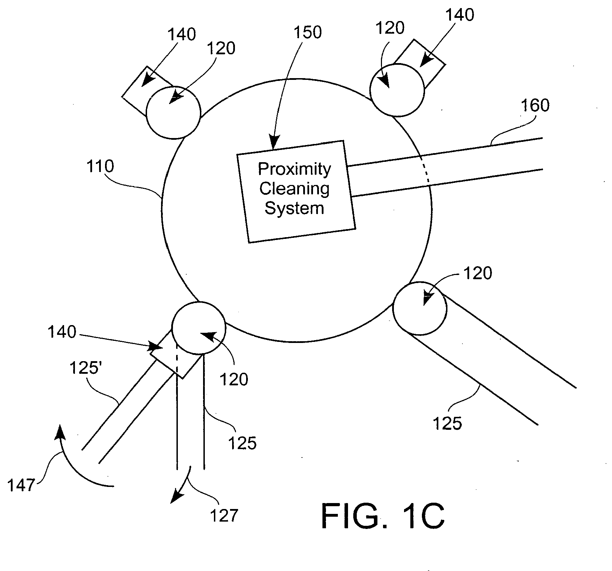

Figure 1C is a top view diagram illustrating a cleaning system, in accordance with yet another embodiment of the invention. In an exemplary embodiment of the present invention of performing cleaning operations, a proximity cleaning system 150 can be used to clean and dry the wafer 110. The proximity cleaning system 150 may include an arm 160 that moves the proximity cleaning system 150 in a cleaning and drying pattern. An exemplary proximity cleaning system 150 is disclosed in United States Patent Application No. 10/261,839, entitled, "Method and Apparatus for Drying Semiconductor Wafer Surfaces Using a Plurality of Inlets and Outlets Held in Close Proximity to the Wafer Surfaces," and filed on September 30, 2002, the disclosure of which is incorporated by reference in its entirety. One of ordinary skill in the art will appreciate that any suitable configuration of the proximity cleaning system 150 is possible, as long as the proximity cleaning system 150 applies fluid to the wafer 110 that is drained according to the method of the present invention.

The cleaning system of Figure 1C illustrates four edge wheels 120 coupled to four edge wheel dryers 140. As illustrated, the robotic arm 125 can move away in a direction 127 to permit the positioning of the wafer 110. Further, another robotic arm 125' coupled to the edge wheel dryer 140 can move in a direction 147. Thus, other embodiments can include any number of robotic arms to move any edge wheel 120 or edge wheel dryer 140.

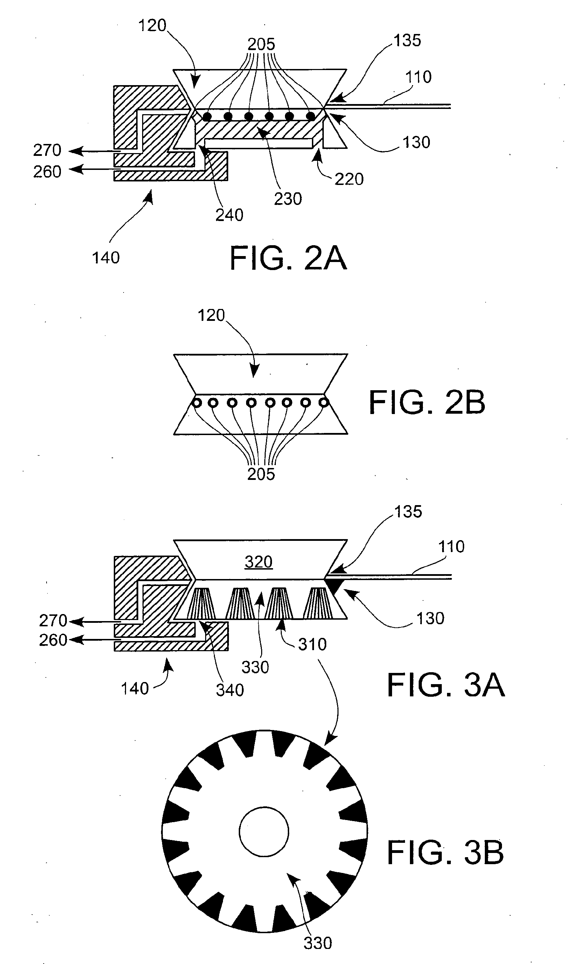

Figure 2A is a side view diagram illustrating a self-draining edge wheel with an internal chamber 230, in accordance with an embodiment of the invention. The edge wheel 120 supports the wafer 110 at an interface. When the wafer 110 is positioned in the groove, fluid at the interface is channeled into edge wheel openings 205. The edge wheel openings 205 channel the fluid from the interface into the internal chamber 230. Thus, as the edge wheel 120 rotates, the edge wheel openings 205 prevent fluid from accumulating at the interface by permitting the fluid to drain into the internal chamber 230. Consequently, no fluid transfer occurs from the interface to subsequent wafers 110 positioned for cleaning.

If an edge wheel dryer 140 is used to suction fluid from the internal chamber 230, then an exemplary edge wheel dryer 140 can include a plurality of vacuum channels. For example, an upper vacuum channel 270 can suction fluid away from the groove. Further, a lower vacuum channel 260 can suction fluid from the internal chamber 230. Specifically, a vacuum port 240 can be inserted into a drain 220 of the edge wheel dryer 120. The drain 220 forms a circular channel in the bottom portion of the edge wheel 120 in which the vacuum port 240 is inserted. The vacuum port 240 is sufficiently fitted to the drain 220 to prevent fluid from escaping the suctioning of the fluid into the lower vacuum channel 260. By preventing the fluid from escaping the suction applied from the lower vacuum channel 260, the bottom surface of the edge wheel 120 is kept substantially dry. It should be appreciated that any number of vacuum channels are possible. For example, the upper vacuum channel 270 may be excluded from the edge wheel dryer 140. It should further be appreciated that if there is more than one vacuum channel in an edge wheel dryer 140, any combination of functioning vacuum channels can be employed. For example, the lower vacuum channel 260 can suction fluid while the upper vacuum channel 270 remains inoperative.

Figure 2B is a side view diagram illustrating a self-draining edge wheel with an internal chamber, in accordance with an embodiment of the invention. The edge wheel openings 205 can have any shape or size. Although illustrated as circular openings on the edge wheel 120, the edge wheel openings 205 can have any suitable shape. The edge wheel openings 205 can also have varying sizes, as long as the sizes of the edge wheel openings 205 permit the fluid to drain into the internal chamber 230. The internal chamber 230 includes a drain to remove fluid from the edge wheel 120. Thus, without using the edge wheel dryer 140, fluid channeled to the internal chamber 230 can be removed.

In addition, there can be any number of edge wheel openings 205 having varying spaces between each edge wheel opening 205. In yet another embodiment, the edge wheel openings 205 can be positioned in multiple rows. For example, there can be two or more rows of each edge wheel openings 205 to permit fluid channeling from the interface formed by the groove and the wafer 110.

Figure 3A is a side view diagram illustrating a self-draining edge wheel with cut out regions 310, in accordance with an embodiment of the invention. Similar to previous embodiments, the edge wheel dryer 140 may or not be used with the edge wheel 120. Here, the edge wheel 120 is composed of a top portion 320 and a bottom portion 330. The top portion 320 and the bottom portion 330 can be manufactured from a single block of material or can be manufactured from two separate blocks of material. If manufactured from two separate blocks, then the top portion 320 and the bottom portion 330 can be coupled together to form the interface that supports the wafer 110. The material can be polyurethane or other similar material. However, any suitable material may be used, as long as the material is a sufficiently rigid material that can support the wafer 110. Further, the material should not generate particles that may contaminate the wafer 110 during the cleaning operation.

In selecting a material for the edge wheel 120, the ability of the material to attract or repel fluid can be considered. The property of a material's ability to attract or repel fluid is the philicity or phobicity of the material, respectively. For example, the fluid, which can include water, deionized water (DIW), a chemistry, a combination of the chemistry and DIW, and a combination of the chemistry and water may be attracted to or repelled from a particular material. It should be appreciated that any suitable fluid and suitable material used in wafer processing systems is possible, as long as the fluid is drained according to the method of the present invention. Thus, when selecting the material, the property of whether the material attracts or repels a particular fluid can be considered during the selection.

The bottom portion 330 of the edge wheel 120 does not have an internal chamber 230, but instead has multiple cut out regions 310. The cut out regions 310 enable fluid to drain towards the bottom surface of the edge wheel 120, thereby preventing the accumulation of fluid at the interface. Specifically, Figure 3B is a bottom view diagram illustrating a self-draining edge wheel with cut out regions, in accordance with an embodiment of the invention. The cut out regions 310 channel fluid from the interface to the bottom surface of the edge wheel 120 during the rotation of the edge wheel. During rotation, the edge wheel dryer 140 can suction the fluid draining towards the bottom surface of the edge wheel 120. In particular, by positioning a lower vacuum channel opening 340 to encompass the fluid draining from the interface, the fluid can be suctioned away from the bottom surface of the edge wheel 120.

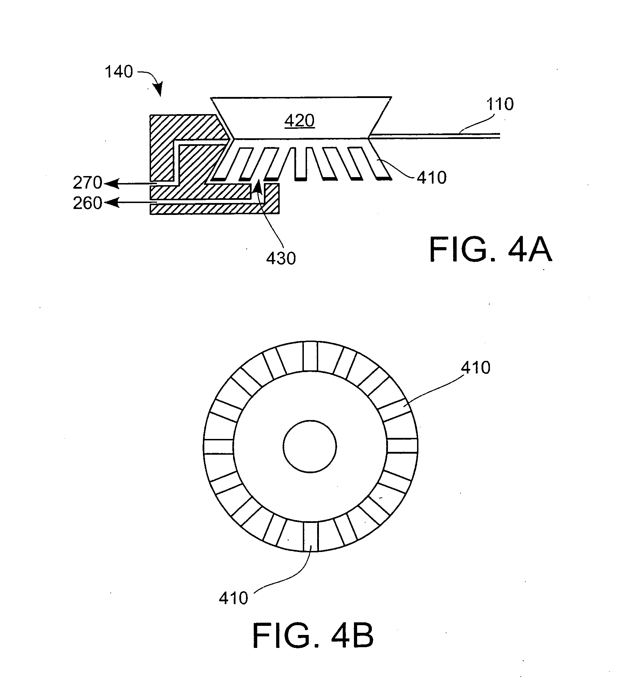

Figure 4A is a side view diagram illustrating a self-draining edge wheel having a plurality of legs, in accordance with an embodiment of the invention. The edge wheel 120 of another embodiment includes a top portion 420 coupled to multiple legs 410. The legs 410 can be manufactured independently of the top portion 420 and can be attached to the top portion 420 via various means. For example, the legs 410 can be screwed into a bottom surface of the top portion 420. The legs 410 are separated by spaces for fluid channeling. As the edge wheel 120 rotates, fluid at the interface drains via the spaces to the bottom surface of the edge wheel 120. Any fluid channeled away from the interface is spun off the bottom surface of the edge wheel 120, thus maintaining a substantially dry bottom surface of the edge wheel 120.

However, if the edge wheel dryer 140 is positioned proximately adjacent to the edge wheel 120, then the edge wheel dryer 140 can suction fluid from the edge wheel 120. For example, the lower vacuum channel 260 can be positioned to suction fluid from the bottom surface of the edge wheel 120 by positioning the lower vacuum channel 260 to encompass fluid spun off the edge wheel 120. Although illustrated with one lower vacuum channel opening 430, the lower vacuum channel 260 can include another lower vacuum channel opening (not shown). Thus, multiple lower vacuum channel openings can suction fluid from various locations of the bottom surface of the edge wheel 120.

Figure 4B is a bottom view diagram illustrating a self-draining edge wheel having a plurality of coupled legs, in accordance with an embodiment of the invention. In another embodiment of the edge wheel dryer 140 (not shown), the lower vacuum channel 260 can extend along the diameter of the bottom surface of the edge wheel 120. Along the length of the lower vacuum channel 260, multiple lower vacuum channel openings suction fluid. Alternatively, one sufficiently large lower vacuum channel opening having sufficient suctioning capability can suction fluid from the bottom surface of the edge wheel 120. Thus, the embodiment of the edge wheel 120 of Figure 4B can have a substantially dry bottom surface.

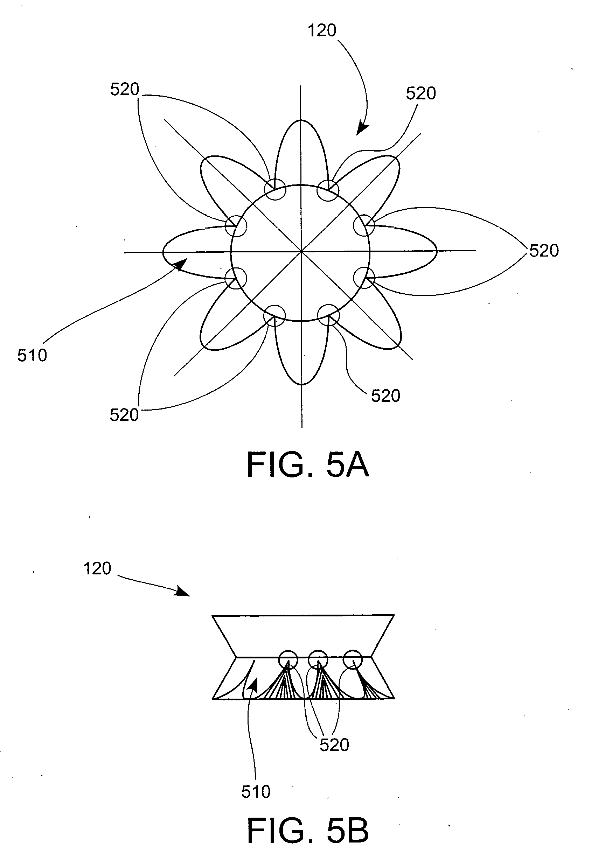

Figure 5A is a bottom view diagram illustrating a self-draining edge wheel with angled channels 520, in accordance with an embodiment of the invention. The edge wheel 120 includes a bottom portion configuration having multiple projections 510 and angled channels 520. Specifically, the projections 510 and the top portion can be manufactured from one material or from various materials. For example, the bottom portion can be coupled to the top portion to form the interface. The angled channels 520 enhance fluid channeling from the interface. Figure 5B is a side view diagram illustrating the self-draining edge wheel with angled channels 520, in accordance with an embodiment of the invention. Specifically, as fluid contacts the interface, the angled channels 520 enhance fluid flow away from the interface by providing a single point from which the fluid drains. Thus, the angled channels 520 prevent the formation of the meniscus of the fluid at the interface.

The embodiment illustrated in Figure 5B may or may not include an edge wheel dryer 140. If using an edge wheel dryer 140 to suction fluid from the bottom surface of the edge wheel 120, then one of ordinary skill in the art will recognize that the edge wheel dryer 140 can have configurations similar to the previously described embodiments.

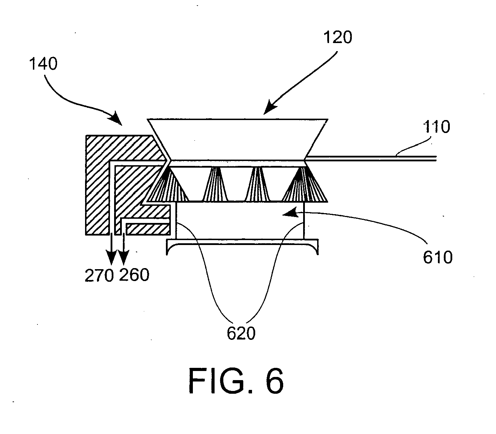

Figure 6 is a side view diagram illustrating a self-draining edge wheel and a fluid conductor 610, in accordance with another embodiment of the invention. The fluid conductor 610 is coupled to the bottom portion of the edge wheel 120 at a center location (not shown). By providing a space beneath the bottom surface of the edge wheel 120, fluid channeled from the interface can flow along the edges 620 of the fluid conductor 610. Specifically, the fluid conductor 610 guides fluid draining from the edge wheel 120 away from the bottom surface of the edge wheel 120. Further, if the edge wheel dryer 140 is positioned to suction fluid flowing along the edges 620 using the lower vacuum channel 260, then the fluid conductor 610 guides any fluid not suctioned by the lower vacuum channel 260 away from the bottom surface of the edge wheel 120. Thus, the bottom surface of the edge wheel 120 is kept substantially dry.

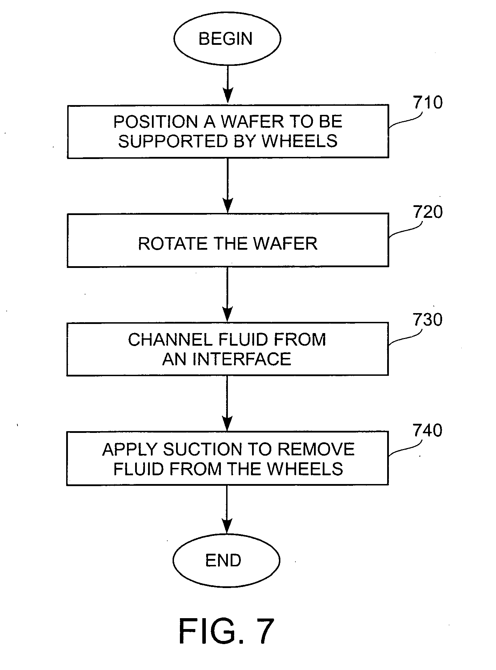

Figure 7 is a flowchart diagram illustrating a method for processing a wafer, in accordance with an embodiment of the invention. The method begins in operation 710 when a mechanism such as a robotic arm positions a wafer to be supported by wheels. Specifically, the wafer is positioned to perform a cleaning operation that cleans a surface the wafer. Positioning the wafer includes a manipulation of the wheel to enable an edge of the wafer to contact a groove of the wheel. Thus, an interface forms at the contact point. In exemplary embodiments, one or both surfaces of the wafer can be cleaned. For example, fluid can be applied to a top surface and a bottom surface of the wafer. Examples of methods to apply fluid include using a proximity cleaning system, spraying mechanisms, and immersion techniques. In other exemplary embodiments, the wafer does not require the application of fluid because the fluid is present on the surface of the wafer when positioned for cleaning. Then, in operation 720, the method includes operations to rotate the wafer. Specifically, as the wafer rotates, the wheels supporting the wafer rotate. During rotation of the wafer, any fluid on a surface of the wafer propagates to the edge of the wafer.

In another embodiment of the present invention, the wafer remains stationary, i.e. not rotating. Further, the wheels may remain stationary. Thus, fluid applied to the surface of the stationary wafer propagates to the edge of the wafer because the volume of the applied fluid sufficiently covers the surface area of the wafer. It should be appreciated that in another embodiment, the wheels may rotate to permit movement of the wafer. However, rotation is not required to propagate fluid to the edge of the wafer.

Next, in operation 730, the method includes operations to channel fluid from an interface. Specifically, the fluid propagated to the edge of the wafer does not accumulate to form a body of fluid having a meniscus. To prevent fluid accumulation, the fluid is channeled away from the interface. Fluid channeling occurs through a combination of a structure of a bottom portion of the wheels and the material composition of the wheels. For example, the structure of the bottom portion can include an internal chamber having openings for draining fluid, cut out regions, a plurality of coupled legs, and angled channels. The structure also includes any of the structures of the embodiments previously described. Further, the material composition of the wheels can consider the phobicity, philicity, and hardness of the material.

Thereafter, in operation 740, the method includes positioning an edge wheel proximately adjacent to the wheels to apply suction to remove fluid from the wheels. It should be appreciated that embodiments of the present invention may or may not apply an edge wheel dryer. Further, the edge wheel dryer can be configured according to the previous embodiments previously described. When using the edge wheel dryer, a vacuum positioned near the bottom portion of the wheels can suction fluid channeled from the interface. Thus, the bottom surface of the wheels remains substantially dry.

To those of ordinary skill in the art, the operations described herein, and illustrated by the drawings, are exemplary. Further, the operations can be performed in any order to permit the draining of fluid from the wheels. Thus, the order of the operations is not limited to any particular sequence.

Although the foregoing invention has been described in some detail for purposes of clarity of understanding, it will be apparent that certain changes and modifications can be practiced within the scope of the appended claims. Accordingly, the present embodiments are to be considered as illustrative and not restrictive, and the invention is not to be limited to the details given herein, but may be modified within the scope and equivalents of the appended claims.

## Claims

1. A method for processing a wafer, comprising:
supporting a wafer with a plurality of edge wheels positioned peripherally around the wafer, the plurality of edge wheels being capable of rotating so as to rotate the wafer;
causing a fluid present on a surface of the wafer to move toward the plurality of edge wheels to reach an interface formed between an edge of the wafer and a surface of each of the plurality of edge wheels; and
channeling the fluid contacting the plurality of edge wheels away from the interface, the channeling of the fluid being configured to prevent formation of a meniscus of the fluid at the interface.

2. The method of claim 1, wherein channeling of the fluid further includes guiding the fluid away from a bottom surface of each of the plurality of edge wheels with a fluid conductor.

3. A method for processing a wafer, comprising:
supporting a wafer with a plurality of edge wheels positioned peripherally around the wafer, the plurality of edge wheels being capable of rotating so as to rotate the wafer;
causing a fluid present on a surface of the wafer to move toward the plurality of edge wheels to reach an interface formed between an edge of the wafer and a surface of each of the plurality of edge wheels;
channeling the fluid contacting the plurality of edge wheels away from the interface, the channeling of the fluid being configured to prevent formation of a meniscus of the fluid at the interface; and
suctioning the fluid from each of the plurality of edge wheels, the suctioning being configured to keep a bottom surface of each of the plurality of edge wheels substantially dry.

4. The method of claim 3, wherein channeling of the fluid further includes guiding the fluid away from the bottom surface of each of the plurality of edge wheels with a fluid conductor.

5. An edge wheel for processing a wafer, comprising:
a top portion and a bottom portion forming a groove therebetween for receiving an edge of a wafer, the bottom portion being configured to channel fluid away from the groove to prevent formation of a meniscus of fluid between the groove and the edge of the wafer.

6. The edge wheel of claim 5, wherein the bottom portion includes a plurality of openings configured to drain fluid to an internal chamber defined in the bottom portion.

7. The edge wheel of claim 6, wherein the internal chamber further includes a drain.

8. The edge wheel of claim 5, wherein the bottom portion includes a plurality of legs to channel fluid.

9. The edge wheel of claim 5, wherein the bottom portion includes angled channels to channel fluid.

10. The edge wheel of claim 5, wherein the bottom portion has cut out regions to channel fluid.

11. The edge wheel of claim 5, wherein the bottom portion is coupled to a fluid conductor, the fluid conductor being configured to guide fluid away from a bottom surface of the bottom portion.

12. The edge wheel of claim 5, wherein the top portion and the bottom portion are manufactured from a single block of material.

13. The edge wheel of claim 5, wherein the top portion and the bottom portion are manufactured from separate blocks of material.

14. A system for processing a wafer, comprising:
a plurality of edge wheels for supporting a wafer, each of the plurality of edge wheels having a top portion and a bottom portion forming a groove therebetween for receiving an edge of a wafer, the bottom portion being configured to channel fluid away from the groove to prevent formation of a meniscus of fluid between the groove and the edge of the wafer; and
an edge wheel dryer disposed proximate to the plurality of edge wheels, the edge wheel dryer having a plurality of vacuum channels configured to suction fluid away from the bottom portion of each of the plurality of edge wheels.

15. The system of claim 14, wherein the bottom portion includes a plurality of openings configured to drain fluid to an internal chamber defined in the bottom portion.

16. The system of claim 15, wherein the internal chamber further includes a drain.

17. The system of claim 14, wherein the bottom portion of the edge wheel includes a plurality of legs to channel fluid.

18. The system of claim 14, wherein the bottom portion of the edge wheel includes angled channels to channel fluid.

19. The system of claim 14, wherein the bottom portion has cut out regions to channel fluid.

20. The system of claim 14, wherein the bottom portion of the edge wheel is coupled to a fluid conductor, the fluid conductor being configured to guide fluid away from a bottom surface of the bottom portion.

21. A method for processing a wafer, comprising:
supporting a wafer with a plurality of edge wheels positioned peripherally around the wafer;
applying a volume of fluid on a surface of the wafer, the volume of fluid being sufficient to cause the fluid to move toward the plurality of edge wheels to reach an interface formed between an edge of the wafer and a surface of each of the plurality of edge wheels; and
channeling the fluid contacting the plurality of edge wheels away from the interface, the channeling of the fluid being configured to prevent formation of a meniscus of the fluid at the interface.

22. A method for processing a wafer, comprising:
supporting a wafer with a plurality of edge wheels positioned peripherally around the wafer;
applying a volume of fluid on a surface of the wafer, the volume of fluid being sufficient to cause the fluid to move toward the plurality of edge wheels to reach an interface formed between an edge of the wafer and a surface of each of the plurality of edge wheels;
channeling the fluid contacting the plurality of edge wheels away from the interface, the channeling of the fluid being configured to prevent formation of a meniscus of the fluid at the interface; and
suctioning the fluid from each of the plurality of edge wheels, the suctioning being configured to keep a bottom surface of each of the plurality of edge wheels substantially dry.
